Europäisches Patentamt

European Patent Office

Office européen des brevets

(19)

(11) **EP 1 249 857 A1**

(12) # EUROPEAN PATENT APPLICATION

(43) Date of publication:
**16.10.2002 Bulletin 2002/42**

(51) Int Cl.7: **H01L 21/00**

(21) Application number: **01108880.4**

(22) Date of filing: **09.04.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Infineon Technologies AG
81669 München (DE)**

(72) Inventor: **Kuerner, Wolfgang
01471 Radeburg (DE)**

(74) Representative: **Epping Hermann & Fischer
Ridlerstrasse 55
80339 München (DE)**

(54) **Semiconductor wafer detecting apparatus and method for detecting a semiconductor wafer in a slot of a wafer carrier**

(57)     An inductor (1) or capacitor (2) generate a magnetic or electrical field, which is influenced in the case of the presence of a semiconductor wafer (5) in a slot (4) of a wafer carrier or container (20). Due to the relative dielectric permittivity or the magnetic susceptibility, the inductivity or capacity of said components (1, 2) changes, which is measured by a measurement device (10). A motor provides a relative movement of semiconductor wafers (5) in occupied slots (4a) through the magnetic field (41) or electrical field (42) for detecting the presence or absence of a semiconductor wafer (5). A control unit (6) combines the information about the capacity or inductivity change from the measurement device (10), and positional information of the wafer slots from motor (3). Using the wafer detecting apparatus the problem of detecting coated wafers is solved and cross- or double-slotted wafers (52) are easily detected.

Fig. 1

EP 1 249 857 A1

# Description

The present invention relates to a semiconductor wafer detecting apparatus, for detecting the presence or absence of a semiconductor wafer in a wafer slot, and a method for detecting a semiconductor wafer in a wafer slot of a wafer carrier.

The transfer of semiconductor wafers in a semiconductor fabrication facility between different types of processing tools, each performing a specific manufacturing step of the wafer, is commonly provided by injection-molded containers, the so-called wafer carriers. Such a wafer carrier typically comprises a number of slots for receiving semiconductor wafers, which are ordered vertically one above the other. In the case of the wafer carrier being a front-opening unified pod (FOUP) the front of the carrier can be removed for loading or unloading a wafer from or to a slot. An example is to deposit a wafer carrier at a load port of a processing tool, where the front door removal and the wafer extraction are performed automatically by means of detecting sensors and by a fork lift, which raises the wafer from its backside being directed to the bottom direction of the carrier, and then removing the wafer from the carrier into the processing tool, where some processing is started on the wafer.

In order to perform these transfer steps the automation means needs to know the position of the slots and the information, whether a wafer is present or absent in a slot. For example, it may occur that a semiconductor wafer generated a problem in a preceding processing step, by which the semiconductor wafer is taken away from further manufacturing so that the corresponding slot in the wafer carrier will remain empty for the following steps. Another example is the sampling of test wafers for inspection at a preceding step. Alternatively, there may be deposited a semiconductor wafer in a slot, which originally was not supposed to receive a wafer. The automation system therefore has to be given notice of that wafer. For this reason common processing tools comprise semiconductor wafer detecting apparatus - also called wafer scanner which is not to be confused with the corresponding type of exposure tool - which serves for detecting a semiconductor wafer in a slot by means of a photo-emitting element and a photo-detecting element. The detection is performed by emitting a light onto the wafer, typically onto its edge and either detecting the reflected light in case of the presence of the wafer by the photo-detecting element or not receiving the light by the photo-detecting element being positioned on the opposite side of the wafer due to the wafer obscuration of light. The latter type of wafer scanner is described, e.g., in US 5,780,849, where the corresponding wafer carrier has openings on the front and backside, such that the optical axis between the photo-emitting element and the photo-detecting element is positioned exactly in the plane of a wafer or slot. The wafer carrier being, e.g., partly filled with wafers is then lifted with respect to the elements by means of a pulse motor, whereby the pulses are recorded by a control unit for retrieving number coordinates of the wafer carrier slots. Each time the optical axis is obscured during the lifting the photo-detecting element notices a light minimum, which is submitted to the control unit. For these time dependent coordinates the control unit stores the information, that a semiconductor wafer is present or absent, respectively.

For the former case of reflection of light just a front-opening of the wafer carrier is necessary. The process of wafer mapping, i.e. scanning of occupied or empty slots in a carrier, either the photo-elements or the carrier or both can be moved relative to each other. Since light source and detector can easily be combined into a device having a small spatial extent, a non-circumstantial apparatus can be supplied to each processing tool in the facility. Moreover, standardised FOUPs can be used as wafer carriers.

On the contrary a disadvantage arises due to the so-called blue wafer effect. This occurs, when coated wafers, e.g. having received a nitride deposition in a CVD (chemical vapour deposition)-process, are to be detected in a wafer carrier. Due to destructive interference and/or absorption the reflected light results in a poor signal for certain thickness of the coating layer even on the edge of the wafer in the photo detecting element. Since a threshold of the photoelectric signal is not exceeded, a semiconductor wafer might not to be detected and the automation means supposes the absence of a wafer in the corresponding slot. If then the system tries to deposit a semiconductor wafer, that just has been processed in the processing tool, into said slot which is supposed to be empty the structured layer surface of at least one of the two wafers might be damaged or even a wafer breakage occurs, when trying to lift down the wafer into the occupied slot using the automation system fork. In worst cases the breakage further leads to a damage of several or all other wafers in the carrier.

It is therefore a primary objective of the present invention to provide a wafer detection in a wafer slot of, e.g., a wafer carrier or wafer container in a processing tool, that is independent of wafer surface characteristics like chemical deposition layers in order to impede damage or breakage during wafer transfer between the carrier or container and the process tool.

The problem is solved by a semiconductor wafer detecting apparatus, for detecting the presence or absence of a semiconductor wafer in a wafer slot, comprising an electrical circuit with at least one inductor or capacitor component for generating an electrical or magnetic field, a measurement device being connected to said at least one component for measuring the inductivity or capacity, a motor for passing an edge of said semiconductor wafer deposited in said wafer slot in a distance from said component through said electrical or magnetic field of the at least one inductor or capacitor, a control unit for issuing a signal indicating the presence or absence of the wafer in said slot, which is connected to said motor and said measurement device, and by a method of using the apparatus for detecting the semiconductor wafer in a slot of said wafer carrier.

A magnetic field is generated by an inductor, e.g. a coil, or an electrical field is generated by a capacitor, and the wafer can be detected by influencing the field due to the material characteristics of the wafer, particularly the substrate. A main advantage is, that obscuring or absorbing surface layers, e.g. due to being coated with nitride in a CVD-process, do not contribute substantially to the field change. Thus, a process specific state of a wafer plays a minor role for the present apparatus. Rather, the characteristics of the wafer, i.e. the relative dielectric permittivity or the magnetic susceptibility of the substrate composition determine the outcome of the field change. In the case of semiconductor wafers the substrate consists substantially of silicon having a relative dielectric permittivity $\varepsilon_r = 11.7$ and a molar magnetic susceptibility $\chi_m = -3.9 \cdot 10^{-9}$. At a nearest distance of the inductor or capacitor component to the semiconductor wafer the capacity of the capacitor is given by

$$C = \frac{\varepsilon_0 \varepsilon_r A}{d},$$

$\varepsilon_0$ is the dielectricity constant, A is the square dimension of the condensator plates and d is the distance of the condensator plates. The inductivity is

$$L = n^2 \cdot \mu_0 \cdot \mu_r \cdot \frac{A}{l},$$

where n is the number of coil loops, $\mu_0$ is the magnetic constant, $\mu_r = 1 + X$ is the relative permeability, A is the coil square dimension and l is a mean magnetic field line length. The capacity or the inductivity are therefore obviously changed, if a semiconductor substrate having material constants $\varepsilon_r$ and $\mu_r$ being different from 1 is entering the space being covered by the electrical or magnetic field.

A measurement device is provided to detect the changed field resulting in a changed inductivity or capacity. Both devices for measuring the capacity or inductivity are well-known from the art. In particular, the electrical circuit and the measurement device may be the same or a part of each other. The capacitor and the inductor may each be implemented individually, i.e. an apparatus with just one or more inductors or an apparatus with just one or more capacitors, or the apparatus according to the present invention may comprise both inductors and capacitors at the same time.

The relative movement for detecting the field change, or the capacity or inductivity change respectively, is provided by a motor, which can be a pulse motor or any other drive. Preferably, the movement is preferably performed along an axis that is orthogonal to the plane defined by a semiconductor wafer occupying a slot. In case of a wafer carrier having 25 slots or the like the distance of this axis to the wafer edges that are passed by the inductor or capacity component is equal for all slots involved. The substrate of a semiconductor wafer therefore always generates the same field change, which can be distinguished from the case of no wafer occupying a slot resulting in no field change. The distance of the axis to the wafer edges is chosen, such that on the one hand a field change can be detected due to sufficient signal strength, and on the other hand the field change due to a wafer in a neighbouring slot can be neglected. Then, a position at which a field change is detected can uniquely be associated with a specific slot in the carrier or container, which is then known to comprise - or not to comprise - a semiconductor wafer.

A control unit combines both the information about the position of the measurement device, the inductor or capacitor component, relative to the slot by e. g. a pulse motor or the like, and the information, whether a field change has been detected, i.e. a semiconductor wafer is present or absent. The control unit therefore is connected to the measurement device and the motor.

The present invention can also be applied to any container for temporarily depositing wafers, e.g. inside a processing tool. Such a container may be provided with just one slot, i.e. it is checked, whether a wafer is at a certain position during processing, or with a series of slots.

In a further aspect the measurement device is considered to comprise a Wheatstone-Bridge, by which the inductivity of the inductor or the capacity of the capacitor can be determined by means of zero balancing a galvanometer suitably switched into the electrical circuit and a variable ohmic resistor. Those bridges are known from the art. In the case of determining the capacity the circuit comprises an additional capacitor, and in the case of determining the inductivity it comprises an additional inductor, e.g. an additional coil.

The method for detecting a semiconductor wafer in a slot of a wafer carrier using the apparatus according to the present invention comprises the steps of providing said wafer carrier to said apparatus, moving said inductor or capacitor component to a position with a distance to the edge of said semiconductor wafer deposited in said slot, generating an electrical or magnetic field with said at least one capacitor or inductor component, detecting a change in the electrical or magnetic field due to the relative dielectric permittivity or the magnetic susceptibility of the semiconductor wafer substrate by means of said measurment device, issuing a signal in response to said detection.

Further aspects and advantages are evident from the dependent claims.

The invention will be better understood by reference to the following description of an embodiment of the invention taken in conjunction with the accompanying drawings, wherein

figure 1     shows an apparatus according to an embodiment of the present invention using a coil as an inductor and a Wheatstone-bridge as part of a measurement device for determining a change in coil inductivity,

figure 2     shows the same embodiment as displayed in figure 1, but with its main components including a motor for lifting the carrier and a control unit,

figure 3     shows a diagram of the measured inductivity L as a function of height position z of the inductor component relative to the slots of the wafer container shown in figure 2,

figure 4     shows another embodiment according to the present invention using a capacitor generating an electrical field,

figure 5     displays a situation with cross-slotted wafers and double-slotted wafers (a), a front view of a wafer container with an apparatus according to an embodiment of the present invention having two inductors for detecting cross-slotted wafers in a carrier or container (b), and a diagram with measured inductivities of both inductors plotted as a function of height position z with the characteristic curves of cross- and double-slotted wafers.

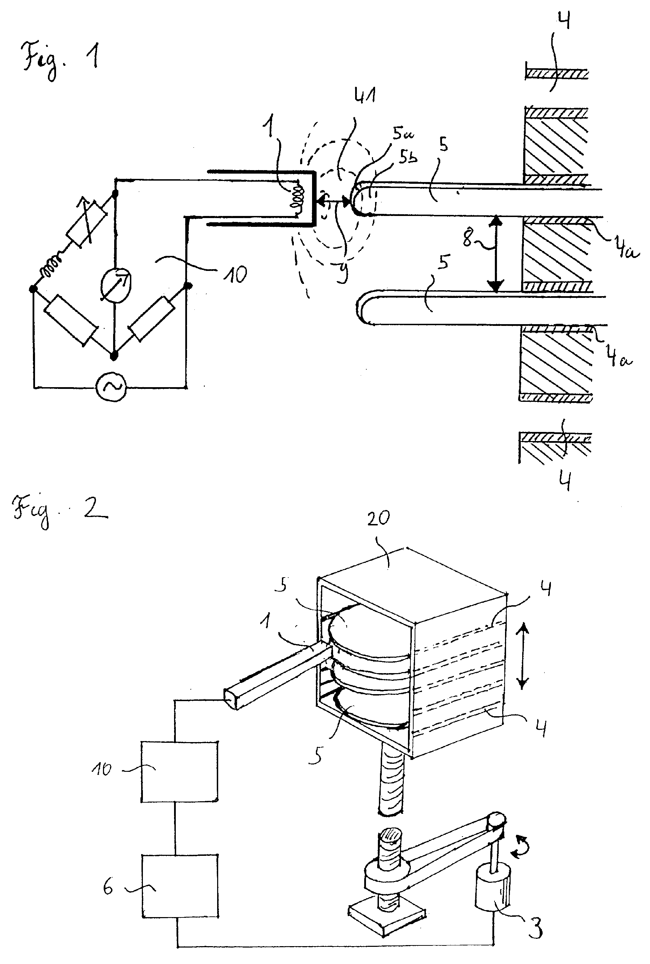

An apparatus according to an embodiment of the present invention is shown in figure 1. An inductor 1 is connected to a measurement device 10 comprising a Wheatstone-bridge with a variable ohmic resistor and a further coil for performing a zero balancing of the electrical current in a galvanometer in said circuit for determining the inductivity of coil 1. The inductor 1 generates a magnetic field 41, which is influenced by a semiconductor wafer 5 brought into the magnetic field 41 with a distance 9 of 2 mm to the inductor 1. The semiconductor wafer 5 possibly is coated with a nitride layer 5a over a substrate 5b, which in case of a wafer detecting apparatus based on photo-diodes would lead to a non-detection due to the blue wafer effect. In this embodiment according to the present invention the magnetic field 41 is influenced by the diamagnetic characteristic of the silicon substrate 5b resulting in a reduced inductivity of the inductor 1, i.e. the magnetic susceptibility is negative and the relative magnetic permeability is smaller than one. The decreased inductivity is detected by periodically determining the inductivity by means of the measurement device 10.

The main components of the apparatus for detecting a semiconductor wafer 5 in a slot 4 of a wafer container 20 (or carrier, respectively) are displayed in figure 2. A relative movement between the inductor 1 according to the present embodiment and the container 20 is provided by a motor 3 that increases or decreases the height level of said container 20. In this embodiment the position of the inductor 1 is fixed, the movement of the semiconductor wafers 5 in the container 20 is along an z-axis such that the nearest possible distance 9 of the wafer edges of the semiconductor wafers 5 to the inductor 1 is the same for all wafers.

The container comprises five slots 4, four of which are filled with semiconductor wafers 5 having a pitch 8 of 10 mm. For performing a wafer mapping the motor 3 increases the height level of the container 20, thereby sending positional information of the height level to the control unit 6. While all wafers 5 in said slots 4 subsequently pass the nearest distance 9 position to the inductor 1 the inductivity of the inductor 1 is periodically measured by the measurement device 10, and the information is also forwarded to the control unit 6, which combines positional and inductivity information of the wafers or slots in said container. A changed inductivity signal corresponds to a detection of a semiconductor wafer 5 in the corresponding slot 4. An initial gauging would be preferable, if just few wafers are present in the container 20 in order to define the positional coordinates of the first slot 4, that has to be measured.

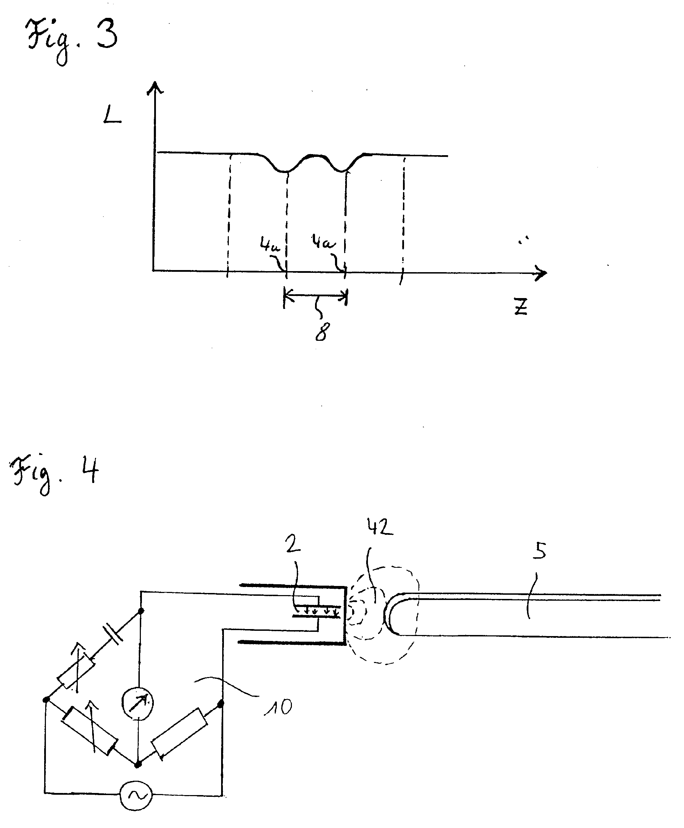

An example of the measured inductivity of the slot configuration of a wafer carrier displayed in figure 1 is shown in figure 3. There, the inductivity L is plotted versus the position z. On this z-axis the position of the four displayed slots 4, 4a are indicated. Those slots 4a filled with semiconductor wafers 5, i.e. the 2 innermost slots, evidently reveal a decrease of the inductivity due to the silicon material characteristic. The slots 4 not being occupied with a semiconductor wafer 5 do not reveal a signal change in inductivity and will therefore be considered to comprise no semiconductor wafer inside indicated by control unit 6.

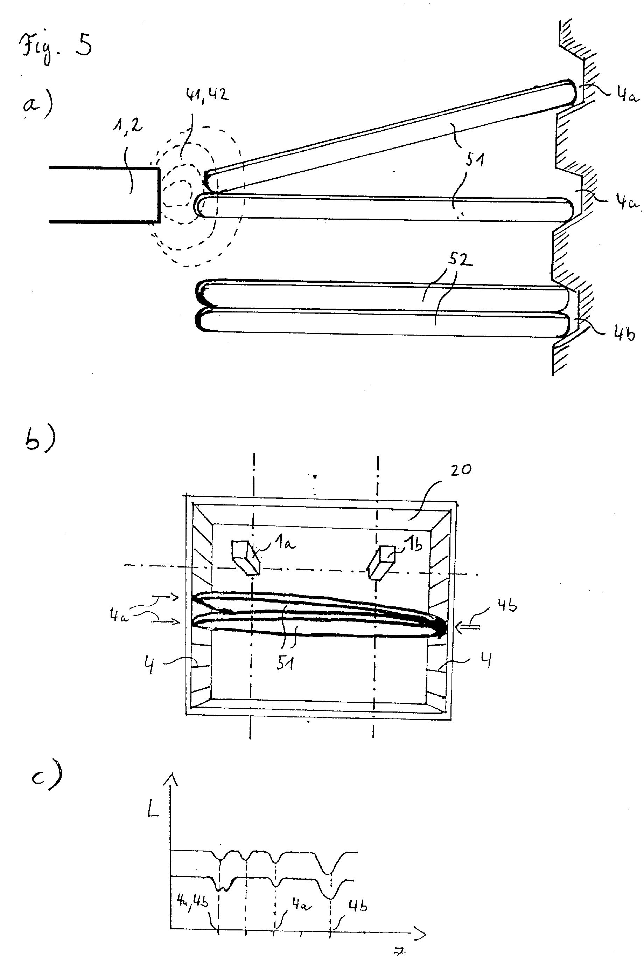

A further embodiment of the present invention is displayed in figure 4. An electrical field 42 is generated by capacitor 2 connected with a corresponding Wheatstone-bridge of a measurement device 10 providing a capacity determination by means of zero balancing with a galvanometer. The electrical field 42 is similarly changed due to the introduction of the semiconductor wafer 5 thereby changing the capacity of the capacitor 2. With a relative dielectric permittivity of $\varepsilon_r = 11.7$ even a peripheral crossing of the capacitor field retrieves a sufficient capacity change signal.

In another embodiment a detection of cross-slotted 51 or double-slotted wafers 52 in a container or carrier 20 is considered. Figure 5a displays the situation of cross-slotted wafers 51 in occupied slots 4a entering the field 41, 42 of an inductor or capacitor component 1, 2. Since in this case the mass of the influencing substrate material is twice as large, e.g. the detected inductivity signal as measured in a position, where both wafers 5 touch each other, also emerges to be changed twice as strong. Thus, the apparatus and method according to the present invention provide the immediate detection of irregular wafer deposition in a carrier 20. If a field change signal exceed a certain threshold level being sufficiently larger than that of a single wafer, a warning signal may be issued for informing the operator about the problem.

Furthermore, the subsequently measured carrier slot (the one above the slot curently being measured in figure 4a) accordingly supplies no field change signal, while the edge of the wafer being opposite to the inductor 1 or capacitor 2 occupies parts of the slot 4a. According to this embodiment as shown in figure 5b two inductor or capacitor components 1a, 1b measuring at different positions relative to the carrier 20 are used. They take the same height position, such that a correctly deposited semiconductor wafer 5 evokes about the same signal in both components. In case of cross-slotted wafers 51 the detection of inductivity or capacity change signals would differ in time, i.e. position of mapping, and a warning signal can be issued by control unit 6 to inform an operator about the problem. The corresponding signals are displayed in figure 5c on the left hand side.

The case of double-slotted wafers 52 in a double occupied slot 4b is also displayed in figure 5a. Here, just a synchronous signal can be detected for both inductors or capacitors 1a, 1b, but both components measure a twice as large signal, displayed on the right-hand side of figure 5c. A warning signal is generated and informs an operator about the cause of the problem. Advantageously, semiconductor wafers 5, 51, 52 can be rescued and prevented from being damaged, resulting in an increased wafer yield.

List of reference numerals

1    inductor
2    capacitor
3    motor
4    wafer slot
4a    occupied slot
4b    double occupied slot
5    semiconductor wafer
6    control unit
8    pitch, vertical distance of wafers
9    nearest distance component-wafer
10    measurement device, wheat stone-bridge
20    wafer carrier, wafer container
41    magnetic field
42    electrical field
51    cross-slotted wafers
52    double-slotted wafers

**Claims**

1. Semiconductor wafer detecting apparatus, for detecting the presence or absence of a semiconductor wafer (5) in at least one wafer slot (4), comprising

   - an electrical circuit with at least one inductor (1) or capacitor (2) component for generating an electrical (42) or magnetic field (41),
   - a measurement device (10) being connected to said at least one component (1, 2) for measuring the inductivity or capacity,
   - a motor (3) for passing an edge of said semiconductor wafer (5) deposited in said wafer slot (4) in a distance (9) from said component through said electrical (42) or magnetic (41) field of the at least one inductor (1) or capacitor (2),
   - a control unit (6) for issuing a signal indicating the presence or absence of the wafer in said slot (4), which is connected to said motor (3) and said measurement device (10).

2. Apparatus according to claim 1,
   **characterised by**
   said measurement device (10) comprises a Wheatstone-Bridge with at least an additional capacitor or inductor component and at least one ohmic resistor.

3. Apparatus according to anyone of claims 1 to 2,
   **characterised in that**

   - said at least one wafer slot (4) is one of a number of slots in a wafer carrier (20), which are arranged vertically in said carrier (20) one above the other with a vertical distance,
   - said motor (3) comprises a means for lifting said wafer carrier (20) up and down for passing the egdes of said wafers (5) through said electrical (42) or magnetic (41) field.

4. Apparatus according to anyone of claims 1 to 2,
   **characterised in that**

   - said at leasst one wafer slot (4) is one of a number of slots in a wafer carrier (20), which are arranged vertically in said carrier (20) one above the other with a vertical distance (9),
   - said motor (3) comprises a means for lifting said at least one inductor (1) or capacitor (2) component up and down for passing the egdes of said wafers (5) through said electrical (42) or magnetic (41) field.

5. Apparatus according to anyone of claims 3 to 4,
   **characterised by**
   two sets (1a, 1b) of the each at least one inductor (1) or capacitor (2) component for generating an electrical (42) or magnetic (41) field, each of the two sets having a different position relative to said semiconductor wafer (5) in said wafer slot (4), for detecting a semiconductor wafer (51) being cross-slotted thereby occupying two slots (4).

6. Apparatus according to anyone of claims 3 to 5, **characterised by** a means for directing said magnetic (41) or electrical (42) field towards a plane defined by said semiconductor wafer (5) inside said wafer slot (4).

7. Apparatus according to anyone of claims 3 to 6, **characterised by** wafer slots (4) in said wafer carrier (20) having a vertical distance (8) of more than 10 mm, and said distance (9) between the inductor (1) or capacitor (2) components and the semiconductor wafer (5) being more than 10 mm and less than 30 mm.

8. Method for detecting a semiconductor wafer (5) in a slot (4) of a wafer carrier (20) using the apparatus according to anyone of claims 1 through 7, comprising the steps of

   a) providing said wafer carrier (20) to said apparatus,
   b) moving said inductor (1) or capacitor (2) component to a position with a distance (9) to the edge of said semiconductor wafer (5) deposited in said slot (4),
   c) generating an electrical (42) or magnetic (41) field with said at least one capacitor (1) or inductor (2) component,
   d) detecting a change in the electrical (42) or magnetic (41) field due to the relative dielectric permittivity or the magnetic susceptibility of the semiconductor wafer substrate by means of said measurement device (10),
   e) issue a signal in response to said detection.

9. Method according to claim 8, **characterised in that** a warning signal is issued, if a relative dielectric permittivity or a magnetic susceptibility being measured via the inductivity or capacity differs from that of vacuum or air and that of the substrate (5b) of exactly one semiconductor wafer (5), for detecting double-slotted wafers (52).

10. Method according to claim 8 when referring to claim 5, **characterised in that** a warning signal is issued, if

   - a detection of a semiconductor wafer (51) is recorded by a first of the two sets (1a) for a first slot, while no detection of said semiconductor wafer (51) is recorded for a second slot, and
   - no detection of the semiconductor wafer (51) is recorded by a second of the two sets (1b) for said first slot, while a detection of said semiconductor wafer (51) is recorded for said second slot,

for detecting cross-slotted wafers (51).

Fig. 1

Fig. 2

Fig. 3

Fig. 4

Fig. 5

a)

b)

c)

# EP 1 249 857 A1

**European Patent Office**

## EUROPEAN SEARCH REPORT

Application Number

EP 01 10 8880

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 606 251 A (RYLE ET AL.) 25 February 1997 (1997-02-25) * page 3, line 39-45 * | 1,3,4,6, 8 | H01L21/00 |
| X | US 5 225 691 A (POWERS ET AL.) 6 July 1993 (1993-07-06) * abstract * * page 1, line 60-68 * | 1,8 | |
| A | US 6 179 938 B1 (MANNHART ET AL.) 30 January 2001 (2001-01-30) * abstract * * page 3, line 31-36 * | 1,8 | |
| A | WO 98 57359 A (APPLIED MATERIALS) 17 December 1998 (1998-12-17) * page 3, line 12 – page 5, line 16 * | 1 | |
| A | US 4 409 087 A (QUICK) 11 October 1983 (1983-10-11) * abstract * | 1 | |
| A,D | US 5 780 849 A (KIKUCHI) 14 July 1998 (1998-07-14) * abstract * | 1 | TECHNICAL FIELDS SEARCHED (Int.Cl.7) H01L |

The present search report has been drawn up for all claims

| Place of search | Date of completion of the search | Examiner |
|---|---|---|
| THE HAGUE | 4 October 2001 | Oberle, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

10

**ANNEX TO THE EUROPEAN SEARCH REPORT
ON EUROPEAN PATENT APPLICATION NO.** EP 01 10 8880

This annex lists the patent family members relating to the patent documents cited in the above–mentioned European search report.
The members are as contained in the European Patent Office EDP file on
The European Patent Office is in no way liable for these particulars which are merely given for the purpose of information.

04-10-2001

| Patent document cited in search report | | Publication date | Patent family member(s) | | Publication date |
|---|---|---|---|---|---|
| US 5606251 | A | 25-02-1997 | NONE | | |
| US 5225691 | A | 06-07-1993 | NONE | | |
| US 6179938 | B1 | 30-01-2001 | EP | 0913857 A1 | 06-05-1999 |
| | | | CN | 1216858 A | 19-05-1999 |
| | | | JP | 11238754 A | 31-08-1999 |
| | | | SG | 68692 A1 | 16-11-1999 |
| WO 9857359 | A | 17-12-1998 | US | 6075375 A | 13-06-2000 |
| | | | TW | 407332 B | 01-10-2000 |
| | | | WO | 9857359 A1 | 17-12-1998 |
| US 4409087 | A | 11-10-1983 | NONE | | |
| US 5780849 | A | 14-07-1998 | JP | 8213447 A | 20-08-1996 |
| | | | TW | 406863 Y | 21-09-2000 |

EPO FORM P0459

For more details about this annex : see Official Journal of the European Patent Office, No. 12/82